# EUROPEAN PATENT SPECIFICATION

(11) **EP 2 643 495 B1**
(45) Date of publication and mention of the grant of the patent: **17.05.2017**
(21) Application number: 11794063.5
(22) Date of filing: 22.11.2011
(51) Int. Cl.: C23C 16/455, C23C 16/452, C23C 16/458

(54) **THERMAL GRADIENT ENHANCED CHEMICAL VAPOUR DEPOSITION (TGE-CVD)**
TEMPERATURGRADIENTENERWEITERTE GASPHASENABSCHEIDUNG (TGE-CVD)
DÉPÔT CHIMIQUE EN PHASE VAPEUR AMÉLIORÉ À GRADIENT THERMIQUE (TGE-CVD)

(30) Priority: 25.11.2010 US 954646
(43) Date of publication of application: 02.10.2013
(73) Proprietor: Aixtron SE, 52134 Herzogenrath (DE)
(72) Inventor: TEO, Kenneth B. K., Cambridge Cambridgeshire CB3 6GB (GB); RUPESINGHE, Nalin L., Cambridge Cambridgeshire CB4 3NB (GB)
(74) Representative: Grundmann, Dirk
(86) International application number: PCT/EP2011/070638
(87) International publication number: WO 2012/069451

(56) References cited:
- WO-A1-95/06143
- WO-A1-2009/144456
- JP-A- 7 273 101
- US-A1- 2003 084 848
- US-A1- 2006 062 900
- US-A1- 2008 047 489

## Description

### FIELD OF THE INVENTION

The present invention relates to methods and systems for thermal gradient enhanced chemical vapour deposition of carbon-nanotubes or carbon-nanowires.

### BACKGROUND

The generally accepted growth mechanism for nanotubes and nanowires is the diffusion of gas through a catalyst. One of the factors controlling the rate of diffusion of the gas is the thermal gradient across the catalyst or substrate (see, e.g. R.T.K. Baker, "Catalytic Growth of Carbon Filaments", Carbon, pp. 315-329 (1989); and R.S. Wagner, in Whisker Technology, A.P. Levitt Ed., p. 47 (Wiley, New York, 1970)). Hence, for the growth of nanotubes and nanowires, especially in a vertical direction above a substrate, it is important to control the thermal gradient vertically.

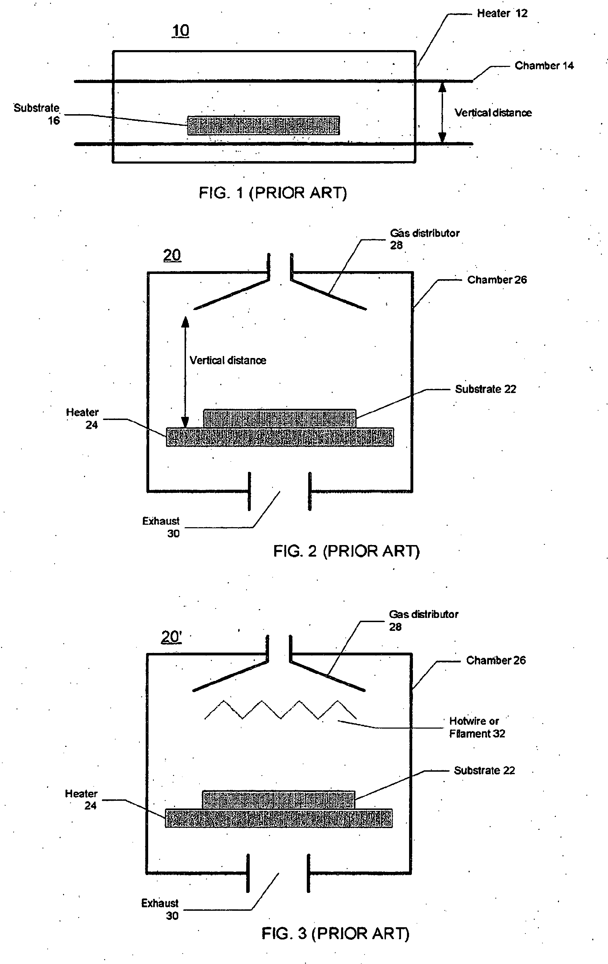

Referring to Figure 1, in a hot wall apparatus 10, a heater 12 surrounds a chamber 14 and heats the chamber, and a substrate 16 within the chamber, to a growth temperature. The gases flow horizontally through the chamber and over the subtrate 16 to promote growth. The chamber and the substrate are at the same temperature and, hence, it is not possible to form a vertical temperature gradient across the wafer.

Referring to Figure 2, in a heated substrate apparatus 20, a substrate 22 is placed on a heater 24 in a chamber 26. The surface is then heated up to the growth temperature. The gases are introduced into the chamber 26 from above (e.g. via gas distributor 28), which cools the top surface of the substrate, and are removed via exhaust 30. This forms a negative temperature gradient because the top side of the wafer is colder than the bottom side of the wafer, which is in contact with the heater. The negative temperature gradient can impede the growth of nanotubes and nanowires. In some cases, a plasma is used to decompose the gases above the substrate, however, the problem of the negative temperature gradient still exists.

Referring to Figure 3, in a hot filament chemical vapour deposition, an apparatus 20' similar to that used in connection with the heated substrate apparatus 20 is used, except that a thin wire or filament 32 is introduced in chamber 26 between the gas distributor and the substrate 22. The thin wire or filament is used to decompose the gases before they reach the substrate. The thin wire or filament is often operated at temperatures in excess of 1000 °C. The wire is often thin and has less than 50% area coverage in order to reduce the heating effects on the substrate. The distance between the wire and the substrate is also fixed.

International application publication WO2008/042691 describes a processing system that includes a substrate holder for supporting and controlling the temperature of a substrate and a hot filament hydrogen radical source of generating hydrogen radicals. The hot filament hydrogen radical source includes a showerhead assembly with a showerhead plate having gas passages facing the substrate for exposing the substrate to the hydrogen radicals, and at least one metal wire filament to thermally dissociate H₂O gas into the hydrogen radicals.

US PGPUB 2002/0132374 describes a deposition process that includes modification of deposition system component parameters (e.g., heating a showerhead or adjusting a distance between a showerhead of the deposition system and a wafer upon which a film is to be deposited), to control the characteristics of a dielectric firm.

US PGPUB 2001/0035124 describes a processing apparatus that includes an upper heater and a lower heater formed above and below a heating chamber. A shower plate is located between the upper heater and the lower heater. N₂ gas is introduced in a gas heating space between the upper heater and the shower plate and is then supplied to the substrate in the form of a shower via the shower plate. The substrate is subjected to convection heat transfer from the N₂ gas that undergoes radial heat transfer from the upper heater, as well as from the heated N₂ gas, and is also heated by the lower heater.

US PGPUB 2004/0129224 describes a processing apparatus with a showerhead for introducing a process gas into a processing vessel, and heaters for heating the showerhead at an elevated temperature. A cooling liquid control system controls the flow of a cooling liquid while the showerhead is being heated and cooled.

JP 2008/001923 describes a film deposition apparatus with substrate heating means for heating a substrate placed on a stage, a showerhead facing the stage and having a large number of gas discharge holes, cooling means provided above the showerhead to cool the showerhead, and heating means provided above the cooling means to heat the showerhead via the cooling means.

US5496410 A discloses a CVD apparatus with two heated precursor gas lines branching from the sources to the deposition chamber.

US2006/0062900 A1 discloses a CVD apparatus with heated gas lines and a heated mixing chamber.

WO95/06143 discloses a CVD apparatus with individually heated nozzles.

### SUMMARY OF THE INVENTION

The present invention provides an apparatus according to claim 1 and a method according to claim 9. In one embodiment, the present disclosure provides a vapour deposition apparatus that includes a chamber configured for chemical vapour deposition of a film on a substrate and which has included therein a lower heater configured to support said substrate and an upper heater disposed a vertical distance above the lower heater. The upper heater has holes therethrough to allow reaction gases to pass vertically from a gas distributor within the chamber towards the substrate. In some instances, area coverage of the upper heater is greater than 50%. Also, either or both of the upper heater and the lower heater may be configured for vertical motion with respect to one another on order to faciliate adjustment of the vertical distance between the heaters. In some cases, the upper heater is integrated with the gas distributor.

A further embodiment of the disclosure provides a vapour deposition apparatus that includes a chamber configured for chemical vapour deposition of a film on a substrate and having included therein a lower heater configured to support said substrate and an upper heater disposed a vertical distance above the lower heater, the upper heater being positioned above a gas distributor having holes therethrough to allow reaction gases to pass vertically towards the substrate. Reaction gases comprise of acetylene, ethylene, methane and/or alcohol. These reaction gases decompose to grow carbon-based films or structures on the substrate, examples are carbon-nanotubes or carbon-nanowires.

Still another instantiation of the vapour deposition apparatus provides a chamber configured for chemical vapour deposition of a film on a substrate and having included therein a lower heater configured to support said substrate and an upper heater disposed a vertical distance above the lower heater, the upper heater being positioned circumferentially around a gas distributor having holes therethrough to allow reaction gases to pass vertically towards the substrate.

In any or all of the foregoing embodiments, the bottom heater may include a cooling element. Likewise, either or both of the upper and lower heaters may be configured for the application of a voltage to create a plasma.

A method consistent with an embodiment of the invention involves establishing a thermal gradient between an upper heater and a lower heater within a vacuum chamber in which a substrate is positioned in the vicinity of the lower heater, and introducing reaction gases vertically into the chamber to create depositions on the substrate. The upper heater may be maintained higher or lower in temperature than the lower heater and the reaction gases may be evacuated from the chamber using a vacuum pump after being made to flow vertically through holes in the upper heater prior to encountering to top surface of the substrate.

Additional embodiments of the invention provide an apparatus having a chamber configured for chemical vapour deposition of a film on a substrate, and including therein a lower heater configured to support the substrate and the gas distributior having an upper heater disposed a vertical distance above the lower heater. The upper heater has a first heating stage with individually heated gas supply lines, and a second heating stage with individually heated gas supply tubes. Multiple ones of the gas supply tubes are supplied by a common one of the gas supply lines. The gas distributor has holes therethrough, each of the holes being aligned with one or more of the individually heated gas supply tubes to allow reaction gases to pass vertically within the chamber from the gas distributor towards the substrate.

Still further embodiments of the invention provide for establishing a thermal gradient by means of a temperature differential between a multi-stage upper heater and a lower heater vertically displaced therefrom within a vaccum chamber in which a substrate is positioned in the vicinity of the lower heater, and introducing reaction gases vertically into the chamber to create depositions on the substrate.

These and other features and embodiments of the present invention are described further below.

### BRIEF DESCRIPTION OF THE DRAWINGS

The present invention is illustrated by way of example, and not limitation, in the figures of the accompanying drawings, in which:
Figure 1 illustrates a conventional apparatus in which the substrates are heated by way of heating elements surrounding a chamber.
Figure 2 illustrates a conventional chamber configured with a single substrate heating element.
Figure 3 illustrates a chamber configured for conventional, hot filament, chemical vapour deposition (CVD) on a substrate.
Figure 4 illustrates an apparatus configured in accordance with one embodiment of the present invention, employing both top and bottom heating elements in a chamber configured for growing nano-structures on substrates.
Figures 5A and 5B illustrate alternative configurations of apparatus configured for thermal gradient enhanced CVD in accordance with embodiments of the present invention.
Figures 6A and 6B illustrate first and second heating stages, respectively, of a multi-stage heating apparatus configured in accordance with an embodiment of the present invention.
Figures 7A and /B are images taken of sample wafers, showing the growth of nano-structures in apparatus configured in accordance with embodiments of the present invention.

### DETAILED DESCRIPTION

Described herein are methods and systems for thermal gradient enhanced chemical vapour deposition (TGE-CVD). In various instantiations, the present disclosure provides a CVD (or other form of deposition) chamber which includes both an upper and lower heater or heating element. The lower heater (which, during operation, may be maintained at a temperature of between 20 - 1000 °C) may be configured to support a substrate or other work piece, and the upper heater (which, during operation, may be maintained at a temperature of between 20 -1000 °C) is disposed a certain distance (e.g., 5-75 mm) above the lower heater. In some instances, the upper heater may have holes running therethrough, to allow gases to pass vertically from a gas distributor within the chamber towards the substrate. For example, the upper heater may be integrated with the gas distributor.

Either or both of the upper and/or the lower heater(s) may be configurated for vertical motion relative to one another. This faciliates adjustment of the vertical distance between the heaters. Further, the area coverage of the upper heater may be greater than 50%.

An alternative instantiation involves a CVD (or other form of deposition) chamber having included therein a lower heater configured to support a substrate and an upper heater disposed a vertical distance above the lower heater, and above a gas distributor. This arragnement allows reaction gases to pas unimpeded in a vertical direction towards the substrate.

Still another instantiation provides an apparatus that includes a CVD chamber. Included in the CVD chamber is a lower heater configured to support a substrate and an upper heater disposed a vertical distance above the lower heater, and being positioned circumferentially around gas distributor having holes therethrough to allow reaction gases to pass vertically towards the substrate. In some instances, the lower heater may include a cooling element. Further, either or both of the upper and lower heaters may be configured for the application of a voltage to create a plasma.

Regardless of the physical instantiations, systems configured in accordance with the present invention are able to establish a thermal gradient between an upper heater and a lower heater within a vacuum chamber in which a substrate is positioned (usually, though not necesarily in the vicinity of the lower heater). Reaction gases are introduced vertically into the chamber to create depositions on the substrate and the temperature gradient is preserved by maintaining one of the heaters higher in temperature than the other.

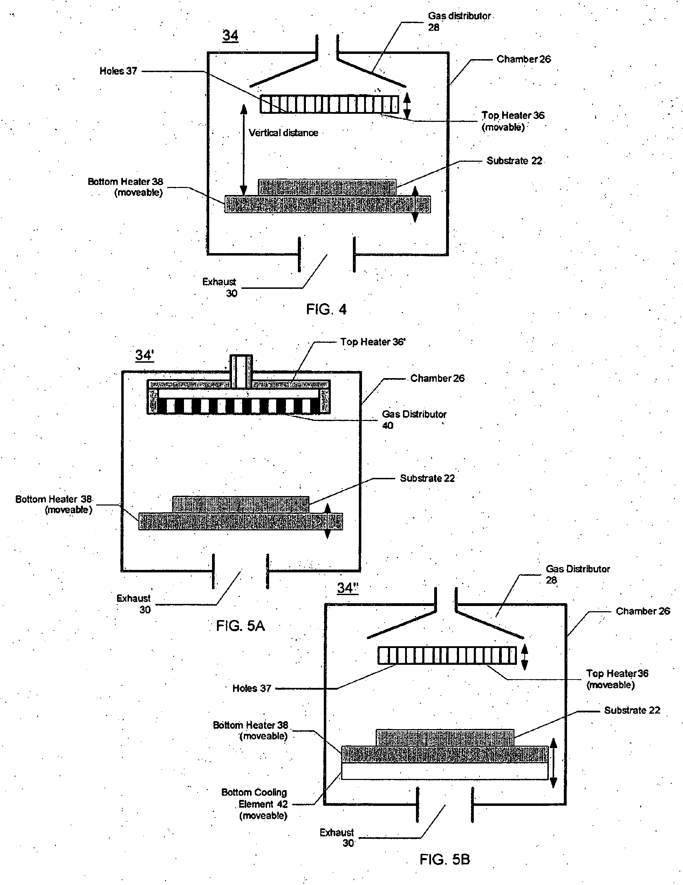

Now referring to Figure 4, an apparatus 34 configured for thermal gradient enhanced CVD in accordance with an embodiment of the present invention is illustrated. The subtrate 22 is placed on a bottom heater 38 within chamber 26. This may be done using a conventional vacuum robotic wafer handler as is known in the art A top heater 36, with holes 37 therethrough to allow the reaction gases to pass vertically from the gas distributor 28 to the substrate 22, is suspended above the substrate 22. The area coverage of the top heater is preferably greater than 50%, to maximise the efficiency of the top heater in creating a vertical thermal gradient within the chamber. Either or both of the top heater 36 or the bottom heater 38 may be moved vertically in order to faciliate the adjustment of the vertical distance between the heaters.

The difference in temperature between the heaters, as well as the distance between the heaters, can be used to control the thermal gradient across the vertical dimension of substrate 22. For example, if the top heater is higher in temperature than the bottom heater, a positive thermal gradient (from the top of the substrate to the bottom of the substrate) is formed. On the other hand, if the bottom heater is higher in temperature than the top heater, a negative thermal gradient (from the top of the substrate to the bottom of the substrate) is formed.

A variety of different chamber/heater configurations may be employed. For example, Figure 5A shows a configuration in which the apparatus 34' includes a top heater 36' (which may be moveable or fixed) that is integrated with a gas distributor 40. Gas distributor 40 may be configured as a showerhead, with multiple gas exit ports or injectors to provide gases in the direction of the substrate. In this particular instance, the top heater 36' is positioned above the showerhead 40, but other embodiments may incorporate these elements in different fashions. For example, the heater may be positioned circumferentially around the showerhead or centrally therein.

Yet a further embodiment is illustrated in Figure 5B. In this implementation, the apparatus 34" includes a bottom heater 38, which itself includes a cooling element 42. Both the bottom heater 38 and the cooling element 42 may be moveable (either collectively or independently of one another) so as to maintain a constant temperature of the substrate 22 if there is excessive radiative heating from the top heater 36 in situations where the top heater is moved into close proximity with the substrate to create a large thermal gradient Additionally, in any of the above-described configurations, voltages can be applied to the top and/or bottom heaters to create a plasma.

In addition to controlling the temperature gradient across the substrate by means of independently moveable top and/or bottom heaters, as discussed above, it is also important to encourage gas phase reactions. The inventors have determinded that good growth conditions for carbon nano-structures correspond to showerhead temperatures on the order of approximately 850 °C, at which temperatures new radicals have been observed to form. In order to increase the path and heating efficieny of the gas introduced into the chamber, a two-stage heating process can be employed before the gas comes into contact with the final heated showerhead plate.

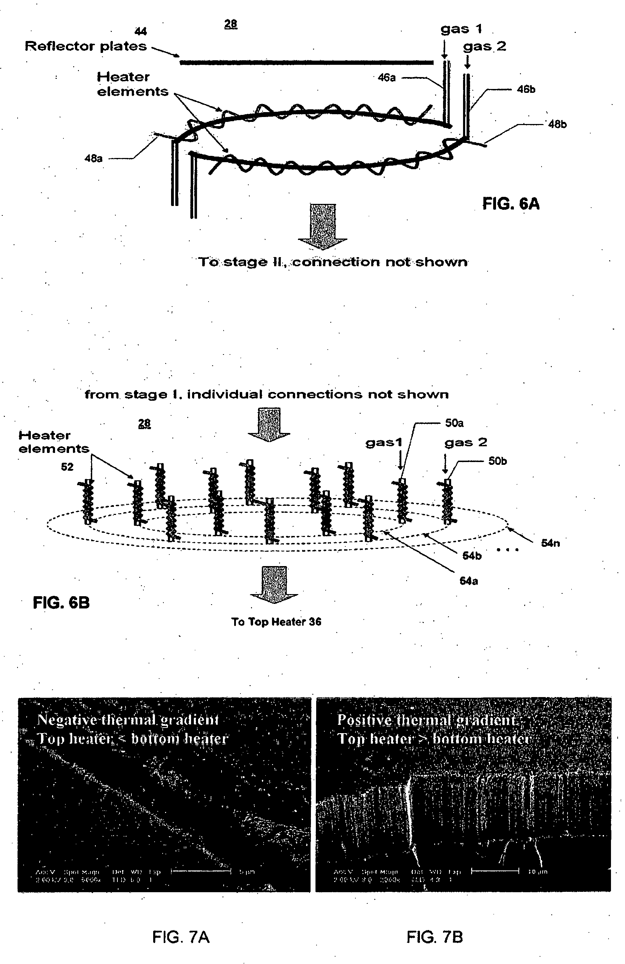

As shown in Figures 6A and 6B, a first part of the two stage heating process may be effected by a first stage of a gas distributor 28 in which gas supply lines 46a, 46b are heated via coiled heating elements 48a, 48b. These heating coils may be controlled independently of one another so that each of the supply gases provided via gas supply lines 46a, 46b are heated to optimal temperatures, or the heating coils may be controlled via a common heating control. One or more reflector plates 44 may be provided for radiant heating. Note that although two gas supply lines are shown in this illustration, other embodiments of the invention may employ more or fewer numbers of gas supply lines, each with their respective heating coil.

The second part of the two stage heating process involves additional individual heating coils. As shown in Figure 6b, from the first stage the supply gases are provided via the gas supply lines 46a, 46b in individual gas supply tubes 50a, 50b. Notice that there are a number of gas supply tubes 50a, for gas provided from gas supply line 46a, and a number of gas supply tubes 50b, for gas provided from gas supply line 46b. The number of gas supply tubes 50a may be more than, less than or equal to the number of gas supply tubes 50b. In general, the gas supply tubes may be positioned in a number of concentric rows 50a, .50b, ....... 50n, about a center (or other point) of the gas distributor 28, and the different rows may have different numbers of the various gas supply tubes 50a, 50b, depending on the type of gas dispersal characteristics desired.

Each of the individual gas supply tubes 50a, 50b are heated via coiled heating elements 52. These heating coils for the different gas supply tubes 50a, 50b may be controlled independenly of one another so that each of the supply gases provided via gas supply tubes 50a, 50b are heated to optimal temperatures, or the heating coils may be controlled via a common heating control. Note that although two groups of gas supply tubes are shown in this illustration, other embodiments of the invention may employ more or fewer groups of gas supply tubes (in general according to the number of gas supply lines from the first heating stage), each with their respective heating coil.

From this second stage of the two stage heating process, the individual gas supply tubes 50a, 50b supply their respective gases to the top heater 36 illustrated in Figure 4. The individual gas supply tubes 50a, 50b may align with the holes 37 of the heater, or, in some instances, two or more gas supply tubes may share one hole 37 of the top heater 36. In addtion, this top heater 36 may be used as a thermal barrier to prevent sharp thermal gradients for gases leaving tubes 50a and 50b.

Figures 7A and 7B are images taken of sample wafers, each at 650 °C, and illustrate the growth of nano-structures in apparatus configured with top and bottom heaters in accordance with embodiments of the present invention. In Figure 7A, the growth was conducted in a negative thermal gradient environment, in which the top heater had a temperature lower that the bottom heater. In Figure 7B, the growth was conducted in a positive thermal gradient environment, in which the top heater had a temperature greater than the bottom heater.

It should be appreciated that many details of an apparatus suitable for performing the nano-structure growth operations described herein have not been presented in detail so as not to unnecessarily obscure the features of the present invention. Such details would, of course, be required for an operational system, but are known in the art For example, US Patent 5,855,675, assigned to the assignee of the present invention and incorporated herein by reference, provides a good discussion of features which may included in an apparatus that also includes dual heaters in accordance with the present disclosure. In general, such a commercial apparatus may be organized as a cluster-tool-based processing sytem operating substantially within a vaccum chamber. A wafer transfer apparatus may be positioned to operate from the center of the vaccum chamber and be adapted to place and retrieve, by rotation and extension, substrates, typically semiconductor wafers, from and to processing chambers configured in the manner described above and appended at point around the periphery of substantially circular (or square or other shape) vacuum transfer chamber. Wafers may be moved from an outside environment into the vaccum chamber through a load-lock, then through one or more processing chambers, and finally back to the outside environment through an unload lock. Gases used in processing may be introduced via gas feed and control unit through circuit(s) and manifolds, such as the showerhead manifold discussed above. Alternatively, other gas distributor manifolds may be used.

The processing chambers are typically maintained at atmospheric pressure or below atmosphereic pressure through the use of vacuum pumps fluidly coupled to the chamber exhausts. This avoids contamination by atmospheric gases and other particles. During processing in one of the processing chambers, vacuum pumping may be throttled to control process chamber pressure without using excessive quantities of process gases. Such throttling may be accomplished in a number of ways, including by valves having controllable openings. In a typical process cycle, after processing is complete, gases are valved off and the throttling meachanism is opened to allow maximum pumping speed in the processing chamber to a value close to that in the substrate transfer chamber. Then, the processed wafer may be removed from the chamber.

A drive assembly mounted below a processing chamber may be used to raise and lower an internal pedestal on which the substrate support (e.g., the bottom heater) is attached. Alternatively, the bottom heater may be included within such a pedestal. Usually though, the pedestal apparatus will have a heated hearth for supporting and providing heat to a wafer to be processed. When the pedestal is in a lowermost position wafers may be inserted into the chamber and released to lie upon the hearth, and, after the transfer apparatus withdraws, the pedestal may be raised, moving the supported wafer up into a processing position to be processed. The procedure may be reversed when the wafer is to be removed from the processing chamber. Vacuum integrity may be maintained for the overall assembly while allowing vertical freedem of motion for the pedestal by means of a bellows. It will be apparent to those of ordinary skill in the art that there are other mechanisms by which the pedestal assembly may be translated in a vertical fashion, and there are a variety of alterations that might be made without departing from the scope of the invention. There are, for example, a number of different extensible drives that might be used, such as air cylinders, air-oil systems, hydraulic systems, and the like.

Thus, the means for thermal gradient enhanced chemical vapour deposition have been described. Although discussed with reference to several illustrated embodiments, the present invention is not intended to be limited by the examples provided in these illustrations. For example, the methods and systems of the present invention may also be used for controlled growth of thin films via diffusion through intermediate films, either top down or bottom parallel to the direction of the thermal gradient.

## Claims

1. An apparatus, comprising a chamber (26) configured for chemical vapour deposition of a film on a substrate (22), said chamber (26) having included therein a lower heater (38) configured to support said substrate (22) and a gas distributor (28) having an upper heater (36) disposed in a vertical distance above the lower heater (38), the upper heater (36) having a first heating stage (Fig. 6A) with individually heated gas supply lines (46a, 46b) and a second heating stage (Fig. 6B), wherein the upper heater (36) has holes therethrough to allow reaction gases to pass vertically within the chamber from the gas distributor (28) towards the substrate (22), **characterized in that** the second heating stage comprises individually heated gas supply tubes (50a, 50b), wherein multiple ones of the gas supply tubes (50a, 50b) are supplied by a common one of the gas supply lines (46a, 46b), and wherein each of said holes of the upper heater (36) is aligned with one or more of the individually heated gas supply tubes (50a, 50b).

2. The apparatus of claim 1, wherein area coverage of the upper heater (36) is greater than 50%.

3. The apparatus according to one of the preceding claims, wherein the gas supply tubes (50a, 50b) are heated by heating coils, which are controlled independently of one another.

4. The apparatus according to one of the preceding claims, wherein the gas supply tubes (50a, 50b) are positioned in a number of concentric rows (50a, 50b, .....50n), about a centre of the gas distributor (28).

5. Apparatus according to one of the preceding claims, wherein either or both of the upper heater (36) and the lower heater (38) is configured for the application of voltage to create a plasma.

6. An apparatus according to one of the preceding claims, **characterized by** a multi-stage upper heating arrangement configured to present a heating plane between the gas distributor (28) and the substrate (22) with an area coverage of more than 50%, and being adjustable in vertical displacement from the lower heater (38).

7. The apparatus according to one of the preceding claims, wherein the lower heater (38) includes a cooling element.

8. The apparatus according to one of the preceding claims, wherein either or both of the upper (36) heating arrangement and the lower heater (38) is configured for the application of a voltage to create a plasma.

9. A method, comprising establishing a thermal gradient by means of a temperature differential between a multi-stage upper heater (36) and a lower heater (38) vertically displaced therefrom within a vacuum chamber in which a substrate (22) is positioned in the vicinity of the lower heater (38), and introducing reaction gases vertically into the chamber to create depositions on the substrate, **characterized in that** the chamber is a vacuum chamber and the upper heater (36) having a first heating stage (Fig. 6A) with gas supply lines (46a, 46b) and a second heating stage (Fig. 6B) with gas supply tubes (50a, 50b), wherein multiple ones of the gas supply tubes (50a, 50b) are supplied by a common one of the gas supply lines (46a, 46b), wherein the gas supply lines (46a, 46b) and gas supply tubes (50a, 50b) are individually heated.

10. The method of claim 9, wherein the upper heater (36) is maintained higher in temperature than the lower heater (38), thereby providing a positive thermal gradient.

11. The method according to claim 9, wherein the lower heater is maintained higher in temperature than the upper heater (36), thereby providing a negative thermal gradient.

12. The method according to one of the claims 9 to 11, further comprising evacuating the reaction gases from the chamber using a vaccum pump.

13. The method according to one of the claims 9 to 12, wherein the reaction gases are made to flow vertically through holes in the upper heater prior to encountering a top surface of the substrate.

14. The method according to one of the claims 9 to 13, wherein the reaction gases are made to flow vertically through individually heated gas supply lines (46a, 46b) in the upper heater prior to encountering a top surface of the substrate.

15. The method according to one of the claims 9 to 14, wherein the reaction gases are made to flow vertically through individually heated gas supply lines (46a, 46b) and individually heated gas supply tubes (50a, 50b) in the upper heater (36) prior to encountering a top surface of the substrate (22), wherein multiple ones of the gas supply tubes (50a, 50b) are supplied by a common one of the gas supply lines (46a, 46b).

## Patentansprüche

1. Vorrichtung mit einer für eine chemische Gasphasenabscheidung eines Films auf einem Substrat (22) ausgelegten Kammer (26), wobei die Kammer (26) einen unteren Heizer (38) zum Tragen eines Substrates (22) und einen Gasverteiler (28) mit einem in einem vertikalen Abstand über dem unteren Heizer (38) angeordneten oberen Heizer (36) beinhaltet, wobei der obere Heizer (36) einen ersten Heizabschnitt (Fig. 6A) mit individuell beheizten Gasversorgungsleitungen (46a, 46b) und einen zweiten Heizabschnitt (Fig. 6B) aufweist, wobei durch den oberen Heizer (36) Öffnungen hindurchgehen, um Reaktionsgase vertikal innerhalb der Kammer vom Gasverteiler (28) in Richtung des Substrates (22) hindurchzulassen, **dadurch gekennzeichnet, dass** der zweite Heizabschnitt individuell geheizte Gasversorgungsrohre (50a, 50b) aufweist, wobei eine Mehrzahl der Gasversorgungsrohre (50a, 50b) von einer gemeinsamen Gasversorgungsleitung (46a, 46b) versorgt werden, wobei jede der Öffnungen des oberen Heizers (36) zu einer oder mehreren der individuell geheizten Gasversorgungsrohre (50a, 50b) ausgerichtet ist.

2. Vorrichtung nach Anspruch 1, wobei die vom oberen Heizer (36) abgedeckte Fläche größer als 50% ist.

3. Vorrichtung nach einem der vorhergehenden Ansprüche, wobei die Gasversorgungsrohre (50a, 50b) durch Heizwicklungen beheizt werden, welche unabhängig voneinander gesteuert sind.

4. Vorrichtung nach einem der vorhergehenden Ansprüche, wobei die Gasversorgungsrohre (50a, 50b) in einer Anzahl von konzentrischen Reihen (50a, 50b, ....50n) um ein Zentrum des Gasverteilers (28) angeordnet sind.

5. Vorrichtung nach einem der vorhergehenden Ansprüche, wobei der obere Heizer (36) und/ oder der untere Heizer (38) derart ausgebildet sind, dass durch Anwenden einer Spannung ein Plasma erzeugbar ist.

6. Vorrichtung nach einem der vorhergehenden Ansprüche, **gekennzeichnet durch** eine mehrere Abschnitte aufweisende obere Heizanordnung zur Ausbildung einer Heizebene zwischen dem Gasverteiler (28) und dem Substrat (22), wobei eine Fläche von mehr als 50% abgedeckt ist und eine vertikale Beabstandung vom unteren Heizer (38) einstellbar ist.

7. Vorrichtung nach einem der vorhergehenden Ansprüche, wobei der untere Heizer (38) ein Kühlelement aufweist.

8. Vorrichtung nach einem der vorhergehenden Ansprüche, wobei die obere Heizanordnung (36) und/ oder der untere Heizer (38) derart ausgebildet sind, dass durch Anwenden einer Spannung ein Plasma zu erzeugbar ist.

9. Verfahren umfassend: Erstellen eines thermischen Gradienten mittels eines Temperaturunterschieds zwischen einem mehrere Abschnitte aufweisenden oberen Heizer (36) und einem davon innerhalb einer Vakuumkammer vertikal beabstandeten unteren Heizer (38), in welcher ein Substrat (22) in der Nähe des unteren Heizers (38) angeordnet ist, und vertikales Einleiten von Reaktionsgasen in die Kammer, um eine Abscheidung auf dem Substrat zu erzeugen, **dadurch gekennzeichnet, dass** die Kammer eine Vakuumkammer ist und der obere Heizer (36) einen ersten Heizabschnitt (Fig. 6A) mit Gasversorgungsleitungen (46a, 46b) und einen zweiten Heizabschnitt (Fig. 6B) mit Gasversorgungsrohren (50a, 50b) aufweist, wobei eine Mehrzahl der Gasversorgungsrohre (50a, 50b) von einer gemeinsamen Gasversorgungsleitung (46a, 46b) versorgt wird, wobei die Gasversorgungsleitungen (46a, 46b) und die Gasversorgungsrohre (50a, 50b) individuell geheizt werden.

10. Verfahren nach Anspruch 9, wobei der obere Heizer (36) mit einem positiven thermischen Gradienten auf einer höheren Temperatur betrieben wird als der untere Heizer (38).

11. Verfahren nach Anspruch 9, wobei der untere Heizer bei einem negativen thermischen Gradienten bei einer höheren Temperatur betrieben wird als der obere Heizer (36).

12. Verfahren nach einem der Ansprüche 9 bis 11, wobei die Reaktionsgase unter Verwendung einer Vakuumpumpe aus der Kammer evakuiert werden.

13. Verfahren nach einem der Ansprüche 9 bis 12, wobei die Reaktionsgase vor dem Erreichen der oberen Oberfläche des Substrates in einer vertikalen Strömung durch die Öffnungen des oberen Heizers hindurchtreten.

14. Verfahren nach einem der Ansprüche 9 bis 13, wobei die Reaktionsgase vor dem Erreichen der oberen Oberfläche des Substrates in einer vertikalen Strömung durch die individuell geheizten Gasversorgungsleitungen (46a, 46b) hindurchströmen.

15. Verfahren nach einem der Ansprüche 9 bis 14, wobei die Reaktionsgase vor dem Erreichen der oberen Oberfläche des Substrates (22) vertikal durch die individuell beheizten Gasversorgungsleitungen (46a, 46b) und die individuell beheizten Gasversorgungsrohre (50a, 50b) in dem oberen Heizer (36) hindurchströmen, wobei eine Vielzahl von Gasversorgungsrohren (50a, 50b) von einer gemeinsamen Gasversorgungsleitung (46a, 46b) gespeist werden.

## Revendications

1. Un appareil, comprenant une chambre (26) configurée pour le dépôt chimique en phase vapeur d'un film sur un substrat (22), ladite chambre (26) incluant à l'intérieur d'elle un dispositif de chauffage inférieur (38) configuré pour supporter ledit substrat (22) et un distributeur de gaz (28) comprenant un dispositif de chauffage supérieur (36) disposé à une distance verticale au-dessus du dispositif de chauffage inférieur (38), le dispositif de chauffage supérieur (36) ayant un premier étage de chauffage (Fig. 6A) avec des lignes d'alimentation en gaz chauffées individuellement (46a, 46b) et un deuxième étage de chauffage (Fig. 6B), dans lequel le dispositif de chauffage supérieur (36) a des orifices le traversant pour permettre au gaz de réaction de passer verticalement à l'intérieur de la chambre depuis le distributeur de gaz (28) vers le substrat (22), **caractérisé en ce que** le deuxième étage de chauffage comprend des tubes d'alimentation en gaz chauffés individuellement (50a, 50b), dans lequel plusieurs des tubes d'alimentation (50a, 50b) sont alimentés par une des lignes d'alimentation en gaz (46a, 46b) qui leur est commune, dans lequel chacun desdits orifices du dispositif de chauffage supérieur (36) est aligné avec un ou plusieurs tubes d'alimentation en gaz chauffés individuellement (50a, 50b).

2. L'appareil selon la revendication 1, dans lequel la zone de couverture du dispositif de chauffage supérieur (36) est supérieure à 50 %.

3. L'appareil selon l'une des revendications précédentes, dans lequel les tubes d'alimentation en gaz (50a, 50b) sont chauffés par des bobines de chauffage qui sont commandées de manière indépendante les unes des autres.

4. L'appareil selon l'une des revendications précédentes, dans lequel les tubes d'alimentation en gaz (50a, 50b) sont positionnés dans un certain nombre de rangées concentriques (50a, 50b, ...50n) autour d'un centre du distributeur de gaz (28).

5. Appareil selon l'une des revendications précédentes, dans lequel l'un parmi le dispositif de chauffage supérieur (36) et le dispositif de chauffage inférieur (38 ou les deux sont configurés pour appliquer une tension pour créer un plasma.

6. Un appareil selon l'une des revendications précédentes, **caractérisé par** un agencement de chauffage supérieur à étages multiples configuré pour présenter un plan de chauffage entre le distributeur de gaz (28) et le substrat (22) avec une zone de couverture supérieure à 50 %, et qui est ajustable en déplacement vertical par rapport au dispositif de chauffage inférieur (38).

7. L'appareil selon l'une des revendications précédentes, dans lequel le dispositif de chauffage inférieur (38) inclut un élément de refroidissement.

8. L'appareil selon l'une des revendications précédentes, dans lequel l'un parmi l'agencement de chauffage supérieur (36) et le dispositif de chauffage inférieur (38) ou les deux sont configurés pour appliquer une tension pour créer un plasma.

9. Un procédé, comprenant l'établissement d'un gradient thermique au moyen d'un différentiel de température entre un dispositif de chauffage à étages multiples (38) et un dispositif de chauffage inférieur (38) déplacé de lui verticalement à l'intérieur d'une chambre sous vide dans laquelle un substrat (22) est positionné à proximité du dispositif de chauffage inférieur (38), et l'introduction de gaz de réaction verticalement dans la chambre pour créer des dépôts sur le substrat, **caractérisé en ce que** la chambre est une chambre sous vide et le dispositif de chauffage supérieur (36) a un premier étage de chauffage (Fig. 6A) avec des lignes d'alimentation en gaz (46a, 46b) et un deuxième étage de chauffage (Fig. 6B) avec des tubes d'alimentation en gaz (50a, 50b), dans lequel plusieurs des tubes d'alimentation en gaz (50a, 50b) sont alimentés par une des lignes d'alimentation en gaz (46a, 46b) qui leur est commune, dans lequel les lignes d'alimentation en gaz (46a, 46b) et les tubes d'alimentation en gaz (50a, 50b) sont chauffés individuellement.

10. Le procédé de la revendication 9, dans lequel le dispositif de chauffage supérieur (36) est maintenu à une température supérieure que le dispositif de chauffage inférieur (38), procurant de ce fait un gradient thermique positif.

11. Le procédé selon la revendication 9, dans lequel le dispositif de chauffage inférieur est maintenu à une température supérieure que le dispositif de chauffage supérieur (36), procurant de ce fait un gradient thermique négatif.

12. Le procédé selon l'une des revendications 9 à 11, comprenant en outre l'évacuation des gaz de réaction de la chambre en utilisant une pompe à vide.

13. Le procédé selon l'une des revendications 9 à 12, dans lequel on fait passer les gaz de réaction verticalement à travers des orifices dans le dispositif de chauffage supérieur avant de rencontrer une surface supérieure du substrat.

14. Le procédé selon l'une des revendications 9 à 13, dans lequel on fait passer les gaz de réaction verticalement à travers des lignes d'alimentation en gaz chauffées individuellement (46a, 46b) dans le dispositif de chauffage supérieur avant de rencontrer une surface supérieure du substrat.

15. Le procédé selon l'une des revendications 9 à 14, dans lequel on fait passer les gaz de réaction verticalement à travers des lignes d'alimentation en gaz chauffées individuellement (46a, 46b) et des tubes d'alimentation en gaz chauffés individuellement (50a, 50b) dans le dispositif de chauffage supérieur (36) avant de rencontrer une surface supérieure du substrat (22), dans lequel plusieurs des tubes d'alimentation en gaz (50a, 50b) sont alimentés par une des lignes d'alimentation en gaz (46a, 46b) qui leur est commune.
